Europäisches Patentamt

European Patent Office

Office européen des brevets

(19)

(11) **EP 0 942 457 A2**

(12) **EUROPEAN PATENT APPLICATION**

(43) Date of publication:
**15.09.1999 Bulletin 1999/37**

(51) Int. Cl.⁶: **H01J 65/04**

(21) Application number: **99102738.4**

(22) Date of filing: **30.09.1993**

(84) Designated Contracting States:
**AT BE CH DE DK ES FR GB GR IE IT LI LU MC NL PT SE**

(30) Priority: **30.09.1992 US 953056**
**18.11.1992 US 976938**
**16.04.1993 US 46671**
**16.04.1993 US 47090**

(62) Document number(s) of the earlier application(s) in accordance with Art. 76 EPC:
**93923758.2 / 0 663 139**

(71) Applicant: **FUSION LIGHTING, INC.**
**Rockville, MD 20855 (US)**

(72) Inventor: **Ury, Michael G.**
**Rockville, Maryland 20855 (US)**

(74) Representative:
**Schwepfinger, Karl-Heinz, Dipl.-Ing.**
**Prinz & Partner GbR**
**Manzingerweg 7**
**81241 München (DE)**

Remarks:
This application was filed on 19 - 02 - 1999 as a divisional application to the application mentioned under INID code 62.

(54) **Electrodeless lamp**

(57) An electrodeless lamp comprises an envelope (12) containing a plasma forming fill which includes at least one of sulfur and selenium when excited which emits principally visible light, which is in the form of molecular radiation. The envelope (12) has a diameter of less than one half inch. Means (1) are provided for generating electromagnetic energy. Further means (2, 3, 4, 5, 6) are provided for coupling said electromagnetic energy to said envelope to excite said fill, which in the absence of envelope rotation or with rotation at an insufficient speed, forms a discharge (14) which does not substantially fill the interior volume of said envelope (12). By additional means (13) the envelope (12) is rotated at a fast enough rate so as to cause the discharge (15) formed by the fill to substantially fill the interior volume of the envelope (12).

FIG. 2

## Description

The present invention relates to improving the operation of electrodeless lamps.

Under certain circumstances, electrodeless lamps will produce a discharge which is isolated to a particular portion or portions of the bulb or envelope rather than being distributed throughout the interior of the envelope.

An example of such a situation is where an electrodeless lamp having a fill wherein sulfur or selenium or compounds of these elements is the primary radiating component utilizes a relatively small bulb.

Electrodeless lamps which utilize sulfur and selenium based fills are disclosed in PCT International Publication No. WO 92/08240, which is incorporated herein by reference. Additionally, it is desirable to use small bulbs in such lamps, for example of less than 1/2" diameter in cases where a bright light source is needed. One such application is in LCD type projection television systems, where the necessity that the source approximate a so-called point light source dictates that the source be spherical in shape and no more than about 1/4" inside diameter (ID).

U.S. Patent No. 4,887,192, assigned in common with the present application, discloses microwave cavities for coupling to small bulbs, i.e., less than 1/2 inch, and is incorporated by reference herein.

However, it has been found that when a small bulb having a sulfur fill (including argon as a starting gas) is installed in a cavity as disclosed in U.S. Patent No. 4,887,192, successful operation is not achieved. Rather, a discharge which is isolated and floats near the top of the bulb is observed, and the spectrum which is outputted by the floating discharge is different than what is expected.

A further problem in the operation of electrodeless lamps, and particularly those which emit visible light is that a "wobble" or "flicker" effect may be present. As used herein, the term "wobble" means any movement in the projected light which is observed by the viewer. This movement may be distracting to the viewer of the projected image, or even cause eye fatigue.

A reason for the wobble effect is that the bulb or envelope is itself visually imperfect and is rotated during operation. Thus, the envelope may have a perturbation, for example, an eccentricity, which would mean that the bulb is slightly out of round if it is a spherical envelope. The envelope in electrodeless lamps may be rotated while cooling fluid (e.g., compressed air) is directed at it to improve cooling, which allows the lamp to be operated at increased power densities, for example, see U.S. Patent No. 4,485,332. It is the rotation of an envelope having a perturbation which results in the visual wobble or flicker when the bulb is rotated at the usual speed for cooling purposes of about 300 RPM.

U.S. Patent No. 4,954,756 teaches to rotate bulbs at speed sufficient to cause a redistribution of the plasma due to centrifugal forces on the fill. For example at column 4, line 30 of that patent, it is stated that for bulbs of from .75 to 1.5 inch diameters rotation rates in the range of from 1500 to 2500 RPM may be used. It should be noted that between the low speed state and the high speed rotated state there is not a significant change in the spectral energy distribution of the bulb, although there is a change in the directional power distribution. The boundary layer effect described in U.S. Patent No. 4,954,756 is different than the isolated discharge effect which is described herein, as in the boundary layer effect the discharge is distributed throughout the interior of the envelope, but is not present at the boundary, whereas in the effect described herein the discharge is not distributed throughout the interior of the bulb volume. Moreover, since the redistribution effect in U.S. Patent 4,954,756 is related to the centrifugal forces on the bulb, a rotation speed of at least 4500 RPM would be dictated for one-quarter inch ID bulbs in order to see this effect.

As discussed above, electrodeless lamps are known in which a discharge envelope containing a discharge medium and which does not include electrodes is subject to a microwave or radio frequency (r.f.) electromagnetic field. Once the discharge is initiated by one of many known ignition schemes, the discharge is sustained by the power coupled from the field. The discharge medium, commonly called the fill is carefully chosen so that the radiation produced by the discharge is of the desired character. For example if ultraviolet light is desired a relatively low density mercury fill may be used, whereas on the other hand if visible light for illumination or imaging applications is desired the fill may comprise a suitable mixture of mercury and metal halides. As mentioned above, a further visible fill wherein the radiation is from a substance including sulfur and/or selenium is disclosed in PCT International Publication No. WO 92/08240, which is assigned in common with the instant invention.

For many applications, it is desirable to provide a small bright source, which dictates a small discharge envelope. Examples of such applications are automobile headlights, LCD or similar electro-optic projection systems, and photolithography sources.

U.S.Patents Nos. 4,975,625 to Lynch et al and 4,877,192 to Simpson et al., assigned in common with the instant invention, teach microwave lamps with resonant cavities which subject relatively small discharge bulbs to high intensity fields. However when attempting to couple to even smaller bulbs (inside diameters of 5 to 8 mm,) the resistive losses in the cavity increase, but also the overall Q of the lamps increases, which leads to frequency instabilities when using commercial magnetron sources.

Microwave coaxial electrodeless lamp fixtures, exemplary of which are those taught in U.S. Patent Nos. 3,993,927 to Haugsjaa et al., 4,223,250 to Kramaer et al. and U.S. Patent No. 4,605,701 to Haugsjaa et al. are known from the prior art. Coaxial lamp fixtures generally comprise an inner conductor located close to the discharge bulb and a grounded or opposite polarity structure further, perhaps surrounding or across from the bulb. These fixtures suffer from the problem that the high field and discharge intensity in the bulb next to the inner conductor causes the formation of a localized region of much higher energy density than the surrounding discharge, which attaches to the inside of the wall of the discharge envelope. This quickly melts the bulb, and causes rupture thereof within minutes or seconds. This phenomenon is commonly referred to as arc attachment.

Although not wishing to be bound by theory, it is believed that arc attachment occurs when the plasma which is concentrated close to the bulb envelope causes emission of electrons from the envelope which in turn further intensifies the plasma, leading to a runaway condition, which leads to the formation of an attached arc.

The problem of arc attachment failure is addressed in U.S. Patents Nos. 3,942,058 to Haugsjaa et al and 4,178,534 to McNeil et al. Presented in both patents is the equation Pe-Ph=Pr wherein Pe is defined as the power gained by the electrical excitation, Ph is power lost as heat and Pr is the power of radiated emissions, as well as a second equation $Pe=n_e uE^2$, where $n_e$ is the electron density, u is the electron mobility, and E is the electric field strength. This equation relates the coupled power density to the electric field in a way analogous to an ohmic heating relation. The two patents suggest excitation structure designed to reduce the electric field intensity near the inside of the walls of the discharge envelope so that Pe drops to the point that no radiating discharge occurs near the walls of the envelope and thereby formation of arcs attached to the inside of the discharge wall envelopes is prevented. These patents recognize that prevention of arc attachment can increase the bulb lifetime by several orders of magnitude.

Coaxial fixtures are compact, which is often desirable. However as the size of the bulb is reduced in an effort to produce a small, bright, source, with the operation wavelength remaining fixed at a practical ISM wavelength, the method suggested by the above-noted patents cannot be implemented because it is difficult to create variation of the discharge intensity over the volume of the bulb such that the discharge is isolated from the walls. Moreover, from an optical standpoint, it is undesirable to have a source which is spatially non-uniform.

In attempting to develop microwave lamps with small bulbs, the inventors were confronted with the high field strength requirement for coupling high power densities to small bright bulbs. The common wisdom in the art holds that the problem of arc attachments would be exacerbated in the case of such high power density, high field intensity bulbs.

In electrodeless lamps as described above, it is recognized that high efficiency and low cooling requirement are desirable.

The efficiency of a lamp is a measure of the light radiated as compared with the electrical energy which must be provided to the lamp to produce such radiated light. It is a very important measure of lamp performance because an increase in efficiency of only a few percent can lead to substantial savings in operating costs when a lamp is operated over time.

Additionally, electrodeless lamps become very hot during operation, and are typically cooled by directing pressurized air at the bulb. The use of pressurized air has the disadvantage of being noisy, and the cooling requirements of smaller bulbs are proportionately greater than those of larger bulbs. However, if the efficiency of the lamp can be improved, more of the inputted energy is converted to light, while less is converted to heat, and less pressurized cooling air is required, which accordingly generates less noise.

Conventionally, it has been thought that the efficiency (or efficacy) of a particular discharge lamp is dependent on the discharge fill composition and density, and on the power density which is applied to the fill.

Discharge lamps and particularly electrodeless discharge lamps which contain a condensable fill are known. When the lamp is not operating and cold, the condensable portion of the fill is condensed on the inside of the lamp envelope. These lamps usually also contain a gas which remains gaseous even at low temperatures. This gas facilitates starting as will be described below, and it may also serve the purpose of affecting the performance of the plasma by changing the thermal conductivity of the plasma.

Capacitively coupled, inductively coupled, and microwave excited varieties of electrodeless lamps are known. All of these lamp have in common that the power is supplied to the lamps, not through electrodes which penetrate the bulb, but rather by being subject to an externally produced electromagnetic oscillation. The variation of the pattern of the electromagnetic field, depends on the structure and operation of the external source of the electromagnetic field. Generally there are some areas of the bulb which are subject to higher electromagnetic field, at least during start up.

The starting process of discharge lamps with condensable fill and starting gas has several stages. At first the electromagnetic field is applied, then some minute ionization occurs in the bulb, perhaps by the incidence of a gamma ray from outer space, or as a result of photoelectrons being emitted from the envelope or condensed fill by the action of irradiation from an auxiliary source of ultraviolet light, or by some other agency. The electromagnetic field energizes the electrons and an avalanche breakdown occurs which leads to ionization of the whole starting gas (to some extent e.g. first or second ionization) to form a plasma therefrom. This initial plasma will be relatively low power density and may have a variation in intensity over the interior of the bulb that is different from that of the steady state plasma. The starting gas plasma heats the bulb envelope and thereby causes the evaporation of the condensable fill which is in turn ionized to partake of the discharge. As the condensable fill evaporates, the discharge becomes higher power until all the fill is vaporized and the power reaches its steady state value. The change in power absorbed by the bulb changes, because the impedance of the bulb changes as the condensable fill evaporates and the pressure in the bulb increases.

Upon turning off the power to the lamp, the condensable fill condenses in the area of the interior of the lamp which cools off fastest. This portion may be the area subject to the most forced external cooling e.g. under the cooling air jet, or the area which runs coolest at full power operation.

As discussed above, the starting gas plasma has some variation in intensity over the interior of the bulb. If the starting gas plasma is not very intense in the area of the bulb where the condensable fill condenses it takes a long time to evaporate the condensable fill and thus start the bulb. It may even be impossible, and even if it can be done the interval varies from one start up to the next, i.e., it is not repeatable.

Linear microwave electrodeless lamp made by the assignee of the instant invention direct cooling air and radiate microwave power toward the bulb from the same side. Thus, upon turning off the power, the fill condenses on the side of the bulb which receives power upon restarting the lamp.

In accordance with a first aspect of the present invention, the envelope of an electrodeless lamp which would tend to produce an isolated discharge which does not substantially fill the interior of the envelope if the envelope is not rotated or is rotated at a low speed, is rotated at a high enough speed to cause the discharge to substantially fill the interior of the envelope.

In accordance with a further aspect of the present invention, an electrodeless lamp having a fill including sulfur or selenium which would tend to produce an isolated discharge which does not substantially fill the interior of the envelope if the envelope is not rotated or is rotated at a low speed, is rotated at a high enough speed to cause the discharge to substantially fill the interior of the envelope.

In accordance with a still further aspect of the invention a visually imperfect envelope in an electrodeless lamp, such as an envelope having an eccentricity is rotated at a fast enough rate to eliminate the above-mentioned wobble effect.

According to a further aspect of the invention, the bulb of an electrodeless lamp is rotated to overcome the problem of arc attachment.

In accordance with this aspect, an electrodeless lamp is provided wherein the electromagnetic energy pattern set up proximate the bulb wall is capable of causing arc attachment in the bulb. The bulb is rotated so as to cause regions of the bulb corresponding to regions of the electromagnetic field pattern where arcs are formed to be constantly moving under rotation. It has been discovered by the inventors that the movement tends to eliminate the arc attachment failure mechanism. It is speculated that arcs may be forming near the high field region, but that rotation away from the high field region prevents the arcs from enduring by moving the region where they are forming.

This invention is, in one particular case, applicable to coaxial lamps in which the discharge envelope is positioned near a conductive excitation member which creates high strength fields in at least one part of the volume occupied by the discharge envelope which makes the lamp prone to arc attachment problems. The rotation axis is preferably arranged so that no spot on the bulb wall which comes near the high field region (the region close to the conductive member) of the bulb remains there, but rather so it rotates away. In fact, it is possible with this invention to create conditions that would ordinarily exacerbate the problem of arc attachment, but are desirable from design standpoint: that is high power loaded, small bulbs, without incurring arc attachment problems.

According to an embodiment of this invention, which will be detailed below, a coaxial lamp comprises an inner conductor which creates a high field region near the bulb. The bulb is rotated about an axis which is non-parallel and which is preferably near normal to the inner conductor, such that the bulb is excited uniformly at a high density so as to achieve a uniform bright source, with the result that arc attachment is avoided.

In accordance with a still further aspect of the present invention, improved lamp efficiency and a lower cooling requirement are achieved by rotating an electrodeless lamp bulb which contains a light emitting fill at high speed.

In accordance with the preferred aspects of this part of the invention, the light emitting fill substance is such to produce molecular radiation, including for example, such substances, which when energized, contain polymeric species. The beneficial effects of the invention may be realized to a greater extent when the lamp is excited in a mode where the applied electric field in the fill volume is relatively non-uniform.

It has been discovered that rotating the bulb at high speed results in increased efficiency. Furthermore, the increase in efficiency which is achieved is substantial. A "substantial" increase in efficiency as defined herein means an increase in efficiency of at least about 5% or greater, wherein "efficiency" is defined as the visible light power radiated by the lamp divided by the microwave or r.f. input power. In accordance with the preferred embodiment of the invention which is disclosed herein, the increase in efficiency which is achieved is about 15%.

Additionally, in accordance with the present invention, the lamp may operate with a substantial reduction in cooling requirement. This allows a less noisy source of pressurized cooling fluid to be used, which is an important advantage. As used herein, a "substantially lower" cooling fluid pressure refers to a cooling fluid pressure which is at least about 20% lower than that which would be necessary in the absence of the increase in efficiency which is provided by the high speed rotation.

By way of reference to the prior art, U.S. Patent No. 4,485,332 teaches the idea of rotating an electrodeless lamp envelope while impinging at least one stream of pressurized air on it for the purpose of more effectively cooling the lamp. Before the invention in U.S. Patent No. 4,485,332, pressurized cooling air was impinged on a stationary bulb, with the result that cooling was not as effective, and the lamp had to be operated at lower power densities to prevent overheating.

U.S. Patent No. 4,954,756 discloses the idea of rotating an electrodeless lamp envelope at high speeds (1500-2500 RPM for envelopes of .75 inch to 1.5 inch diameter) to obtain bulb surface temperature equalization and change in the spatial emission properties of the lamp. The patent further teaches that there is an inverse relationship between the required rotation speed and bulb diameter. There is no disclosure that an increase in lamp efficiency is obtained in U.S. Patent No. 4,954,756.

It is disclosed herein that when bulbs of certain sizes are rotated as described, isolated discharges and arc attachment effects do not occur. While the avoidance of these effects is important to the success of lamp operation, increased lamp efficiency is not thereby obtained.

Particular examples of suitable light emitting fill substances are sulfur and selenium, and compounds thereof. Such substances, either by themselves or with additives, have been found to generate light with high efficacy and to provide good color rendition, and lamps which are based on such fill substances are disclosed in PCT International Publication No. WO 92/08240. Also, in a lamp which is excited by a coaxial exciter, the electric field throughout the fill volume is not uniform. Small bulbs, for example, those of less than 1/2 inch diameter are desirable for many applications because of the optical requirements of particular systems, and are encompassed by the present invention.

In a preferred embodiment of an aspect of the invention, it is possible to operate a very small bulb of about 5 mm internal diameter which has a sulfur containing fill and is excited in a coaxial mode, at substantially increased efficiency by rotating the bulb at a high speed of greater than about 8000 RPM.

The invention will be better understood by referring to the accompanying drawings, wherein:

Figure 1a shows an electrodeless lamp bulb in an undesirable mode of operation.
Figure 1b shows an electrodeless lamp bulb in a desirable mode of operation.
Figure 2 shows an electrodeless lamp according to one embodiment of the present invention.
Figure 3 is a schematic illustration of a further embodiment of the invention.
Figure 4 is a schematic illustration of another embodiment of the invention.
Figures 5 to 7 illustrate an aspect of the invention relating to lamp cooling.
Figure 8 shows another embodiment of the invention.

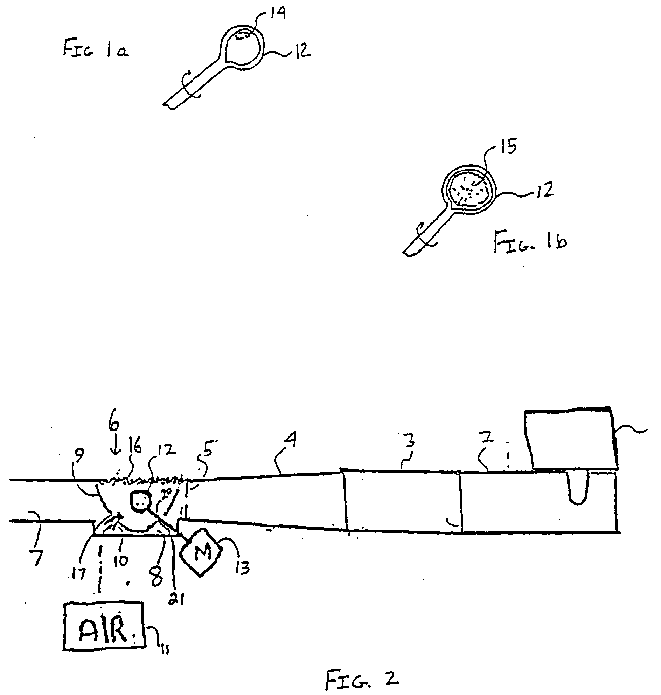

Referring to Figure 1a, an electrodeless lamp bulb 12 is depicted. This lamp bulb is part of an electrodeless lamp (not shown), which as known to those skilled in the art may be powered by microwave or R.F. energy. Many different structures are possible for the electrodeless lamp.

To effect more efficient cooling of the bulb, it is known to rotate the bulb about an axis which is defined by the bulb stem while one or more streams of cooling fluid such as compressed air is directed at the bulb. In the prior art, the bulb is typically rotated at 300 RPM to effect such cooling.

In certain electrodeless lamp arrangements, depending on one or more of bulb excitation, bulb fill, and bulb size, an isolated discharge such as is depicted by reference numeral 14 in Figure 1a will result. This is believed to be caused by the distribution of the electric field density in the bulb in the specific situation.

In the case illustrated in Figure 1a the discharge does not substantially fill the interior volume of the bulb or envelope, and the lamp operates with low efficiency. Additionally, the characteristics of the discharge may be such that it is not usable.

It has been discovered by the inventor herein that when the bulb is rotated at a substantially higher speed, the discharge changes so that it substantially fills the interior volume of the bulb. Additionally, the light output of the lamp increases, and the characteristics of the discharge improve.

The threshold speed at which the discharge begins to fill substantially the interior volume of the bulb will vary with the specific lamp. Additionally, there may be a range of rotation rates within which either the discharge state depicted in Figure 1a or that depicted in Figure 1b or some discharge state in between the two may occur, so the bulb should normally be rotated at a speed above this range where only the discharge state which is depicted in Figure 1b may occur.

Referring to Figure 2, an embodiment of the present invention which depicts a lamp which is powered by microwave energy is shown. Beginning the description at the right side of the figure, a magnetron 1 is coupled to a first section of waveguide 2. These components are arranged so that a TE01 microwave mode is launched in the waveguide with a vertical electric field orientation. The waveguide is connected to a circulator 3 fitted with a dissipative load such as a block of silicon carbide. The circulator is in turn connected to the large end of a tapered waveguide section 4. At the far, smaller end of the tapered waveguide is a coupling iris plate 5. Beyond the coupling iris is a cavity 6 as taught in U.S. Patent 4,887,192 including a vestibule section 7 and a reflector 9. The reflector includes a wire mesh portion 16 on the top side. This embodiment differs from the embodiments shown in U.S. Patent 4,887,192 in that the reflector protrudes from the bottom rather than the top of the vestibule section.

A bulb 12 is supported by its stem 14 at a 60 degree angle with respect to the electric field i.e., the vertical in the drawing. This is in accordance with the teachings of U.S. Patent No. 4,902,935 to Wood et al. which is assigned in common with the instant invention. The bulb is rotated at high speed about an axis concentric with its stem by a motor which is coupled to the stem.

In a particular embodiment as shown, the bulb has a spherical envelope of 9.5 mm ID. The bulb contained a fill of 1.8 milligrams of sulfur and 60 torr of argon. In this embodiment, the threshold angular velocity is 2000 RPM. Below 1500 RPM the undesirable mode of discharge occurs, while above 2000 RPM it does not. Between 1500 and 2000, either may occur so the bulb should preferably be rotated above 2000 RPM in order to rule out operation in the undesirable mode.

Although for the particular lamp shown and described, the necessary rotation speed to stabilize the uniform discharge is 2000 RPM, it is contemplated that for other types of lamps other minimum speeds will be required to stabilize the discharge, and it is noted that the necessary speed can be readily determined by experiment using a variable speed motor.

Referring once again to Figure 2, a dielectric reflector 9 is fitted in the cavity to improve the collection efficiency of the optics. The reflector may be in the shape of an ellipsoid or paraboloid if the lamp is to be used with an LCD projection system. The reflector may be in the shape of an ellipsoid if the lamp is to be used with a film gate type projection system such as a movie projection system.

The bulb stem fits through a hole 15 in the reflector 9. A pressurized air nozzle 10 directs a jet of impinging air at the bulb 12. The air jet fits through a hole 16 in the reflector 9. The air jet is connected to a source of compressed air 11 such as a compressor.

In accordance with a further aspect of the invention the wobble or flicker in an electrodeless lamp which emits visible light is eliminated. Such an effect may be due to a perturbation in the bulb envelope such as an eccentricity of shape or other perturbation. Thus, due to manufacturing tolerances, slight eccentricities are common. When light from the lamp is projected by a reflector and/or lens, the resulting wobble effect can be disconcerting to the viewer.

In accordance with the aspect of the invention, it has been found that the wobble effect can be eliminated by rotating the bulb at a fast enough rate.

For the lamp which is described in connection with Figure 2, it has been found that a rotation rate of 2000-2500 RPM is effective to eliminate wobble. If the light projected by the lamp is magnified, than a higher rate may be necessary.

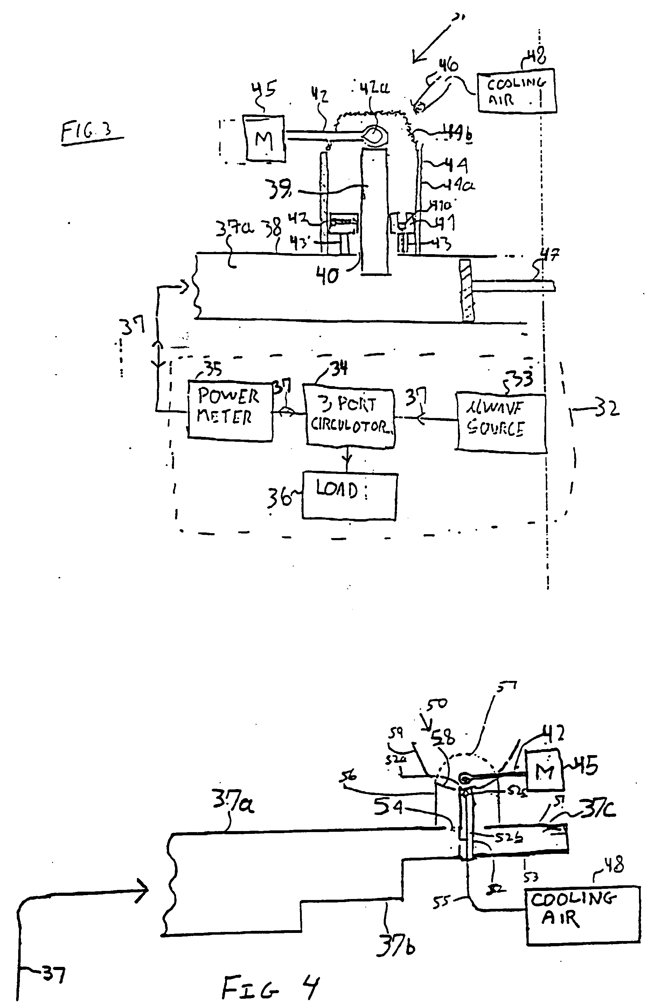

Referring to Figure 3, an embodiment of the invention relating to preventing arc attachment will be described. The lamp fixture generally designated by 31 is fed power from an experimental set up power system generally designated by reference numeral 32.

The power system is configured as follows. A microwave power source 33 such as a commercial microwave oven magnetron produces from several tens to several hundreds of watts of microwave power preferably at the ISM frequency of 2.45Ghz. The source 33 is coupled to a three port circulator 34 which isolates the source 33 from non-absorbed power that is reflected from the fixture 31. The circulator is connected to a power meter 35 which measures forward and reflected power and a dissipative load 36 which absorbs reflected power. Power flows through the power meter 35 to the section of waveguide 37a which is connected to fixture 31.

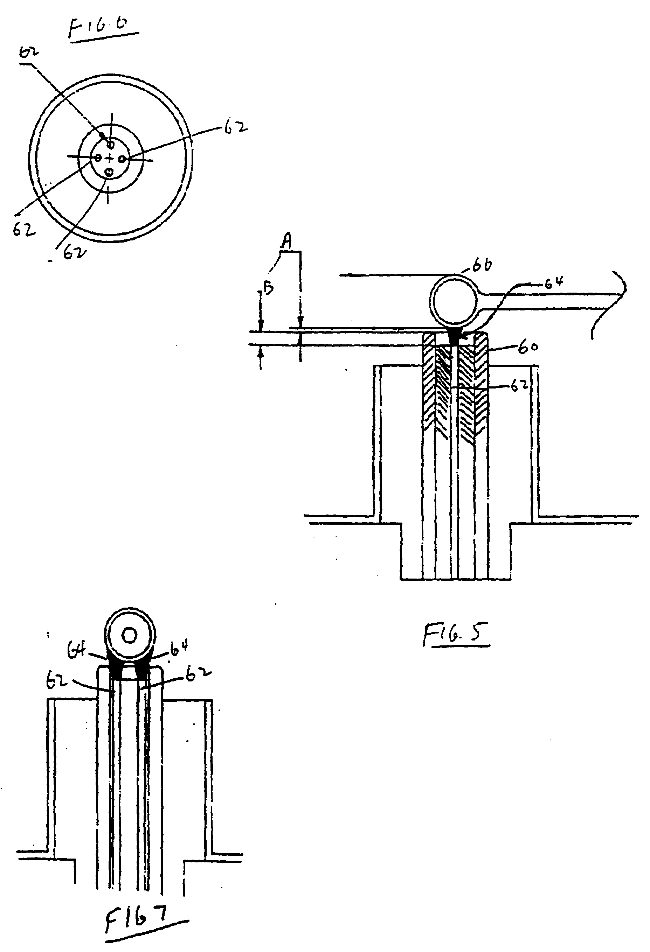

All connection lines designated by reference numerals 37, 37a represent rectangular waveguide. The dissipative load 36 is connected directly to the circulator 34. In a production design, the power system 32 would typically be simplified by eliminating the power meter 35, circulator 34, and dissipative load 36, as in the case of the embodiment of Figure 4 described below.

Continuing with the description of Figure 3, the fixture 31 is mounted on the centerline of the top broadside 38 of rectangular waveguide 37a. The rectangular waveguide, 37,37a is sized to propagate the TE10 microwave mode, so that the electric field is polarized normal to the broadside walls of the waveguide 37a. A hollow, tubular inner conductor member 39 is arranged normal to and inserted in a hole 40 on the centerline of top broadside 38. The hole is slightly larger than the inner conductor 39 so as to provide insulating gap spacing between the inner conductor 39 and the broadside wall 38. The inner conductor is supported by a teflon washer 41 on top of the broad side wall 38, to which it is secured by a nylon set screw 42. The teflon washer 41 is in turn supported by two teflon standoffs 43, 43' to which it is secured by two metal screws (one of which is shown) 41a. The metal screws 41a are countersunk into the teflon washer to prevent arcing to them. The standoffs 43,43' are provided to locate the washer 41 in a region of low electric field in the fixture 31 so that it does not interfere with, or absorb the microwave signal. The top of the inner conductor is positioned near the spherical bulb envelope 42a of the discharge bulb 42. The length of the inner conductor may be selected to achieve resonance. The lower end of the inner conductor extends downward through about 1/6 of the height of the waveguide. This penetration is selected for good coupling between the fixture and the guide 37a. Concentric with and to the outside of the inner conductor 39, hole 40, and washer 41 and also mounted on top broadside wall is the outer conductor 44. The outer conductor 44 comprises a solid cylindrical wall portion 44a which extends up from the top broadside wall 38, and a capped truncated cone shaped mesh portion 44b attached to the top of the cylindrical section 44a closes the chamber formed by the outer conductor 44. The stem of the bulb 42 extends through the mesh portion 44b to the outside of the outer conductor 44, where it is attached to the shaft of an electric motor 45, which is itself supported by a simple support frame not shown in the figure. The stem of the bulb 42 may be normal to the inner conductor 39.

A cooling jet 46 directs air from a cooling air source 48 such as a compressor through the mesh 44b at the bulb envelope 42a. The cooling jet may be positioned so as to direct air normal to both the bulb stem 42 and the inner conductor 39, so that, in other words, the three elements may be mutually perpendicular.

A sliding short 47 is provided in the end of the waveguide 37a for experimental tuning purposes.

In a model built as shown in Figure 3, the frequency of operation was 2.45 GHz. The waveguide 37a used was type WR284. The inner conductor was 0.030 inch O.D., 1.900 inch long and extended 0.270 inch into the waveguide. The solid section 44a of the outer conductor was 1.00 inch I.D. and 1.270 inch tall. The mesh section 44b had a lower base diameter of 1.100 inch and upper base diameter of 0.500 inch and a height of 0.90 inch. The bulb 42a envelope was spherical with a 6.5 MM ID, a volume of 0.144 cubic centimeters and a 0.5 MM wall thickness. The bulb envelope 42a was located 0.030" from a plane across the top of the inner conductor. The bulb envelope 42a contained a fill of approximately 1 milligram of sulphur and 60 torr of argon. 15 PSI of cooling air was supplied to the cooling jet 46 which had a 0.050 inch orifice. The power output of the magnetron was 200 to 300 watts. The bulb was rotated at 3000 RPM. As known to those skilled in the art, the preferred speed will vary with the particular lamp, in dependence on such factors as how prone the fill is to form arcs (e.g. degree of electronegativity), and the magnitude of the applied power.

Referring to Figure 4, a second embodiment of the invention is shown. Elements corresponding to those shown in Figure 3 are designated with the same reference numerals. A microwave source 33 feeds through waveguide sections 37, 37a. The waveguide section 37a is connected to a stepped section 37b which comprises two steps in the height of the waveguide connected to low height section of waveguide 37c. The steps serve as an impedance transformer to partially match the impedance of the waveguide 37,37a to that of the fixture 50 which is mounted on the top broadside 51 of the low height waveguide section 37c. The inner conductor 52 is mounted on the lower broad wall 53 of the reduced height waveguide section 37c, and extends upwards through a hole 54 in the upper broad wall 51. The hole is large enough to provide insulating gap clearance. The top 52a of the inner conductor 52 is located proximate the end of the bulb, typically from a fraction to a few thousandths of an inch. In the embodiment shown, the top 52a of the inner conductor 52 is a spherical surface centered on the bulb. The uniform gap formed between the top 52a of the inner conductor 52 and the bulb provides for more uniform power loading of the bulb 42 surface near the inner conductor 32.

Cooling air is fed from source 48 through line 49 to the bottom of the inner conductor 52 at the lower broad wall 53, through a passage 52b up the length of the inner conductor 52b to one or more cooling air jet orifices 52c in the top surface 52a and is jetted against the bulb 42. The outer conductor comprises a cylindrical wall 56 connected to the upper broad wall 51 and is about as high as the inner conductor 52 and a hemispherical mesh portion 57 joining the cylindrical wall. The mesh 57 serves to contain the excitation energy while transmitting the output of the bulb. Located around the bulb inside the mesh is a dielectric reflector 58. Located around the bulb outside the mesh is a metal reflector 59. The contour of the inner reflector 58 is continuous with the contour of the outer reflector 59.

The stem of the bulb 42 extends through a hole in the mesh 57 to a motor 45, which serves to rotate the bulb during operation which prevents arc attachment in the bulb. The bulb is arranged so that parts of the bulb which come near the high field intensity region near the end 52a of the inner conductor 52 do not remain there but are constantly rotated around.

Tests conducted by the inventors showed that if the bulb is rotated about an axis parallel to the inner conductor 52 so that regions of the bulb remain in the vicinity of the inner conductor 52 end 52a arc attachment and bulb failure occurs within seconds.

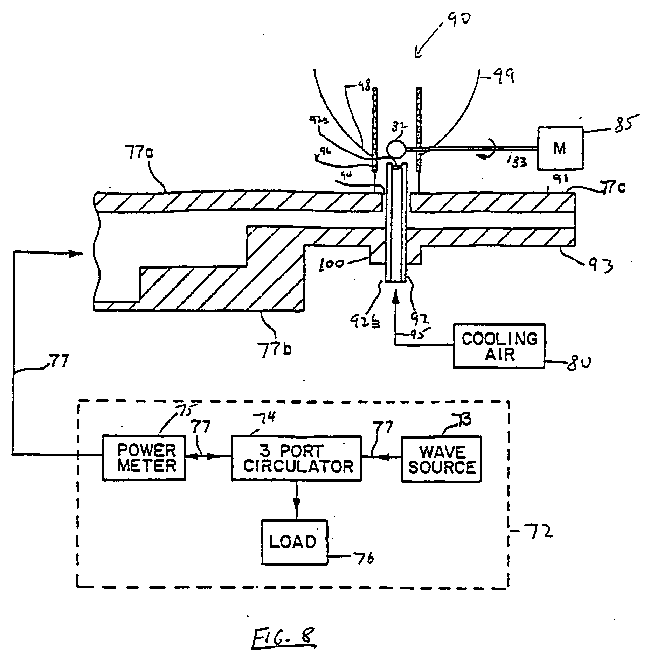

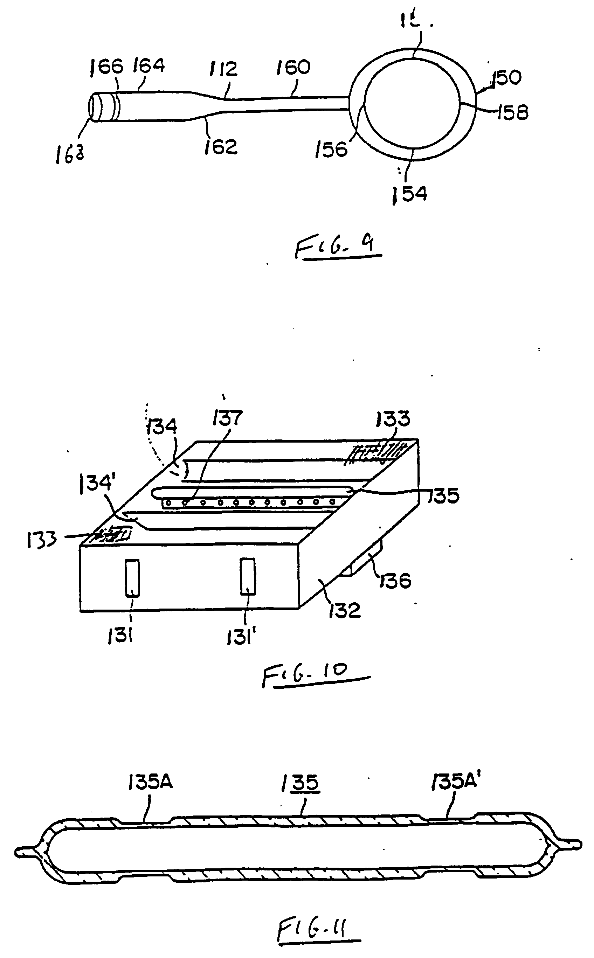

It is noted that the center conductor, from which cooling fluid is emitted, is located very close to the bulb. This is illustrated more clearly in Figures 5 to 7, wherein exemplary coaxial center conductor 60 is shown having a plurality of passageways 62 therein, each of which emits a cooling fluid jet 64 from an opening at the end of the passageway. In accordance with an aspect of the invention, wherein the circular opening through which the cooling jet is emitted has a predetermined diameter, it has been found that improved results are obtained if the opening is located at least as close to the bulb as a distance equal to such predetermined diameter of the opening times three. This would also hold if a typical cooling nozzle (not a coaxial conductor) were used as the cooling source. In a specific arrangement constructed in accordance with Figures 5 to 7, each opening has a diameter of .033" and is situated .08" from the bulb, dimension A being .02" and dimension B being .06".

An advantage of locating the cooling source so close is that it is quieter. Thus, cooling noise may be a problem and the noise increases with the path length of the cooling stream. It has additionally been found that when the cooling source is located very close to the bulb, the cooling jet entrains less of the hot air which surrounds the bulb, and cooling is more efficient.

Referring to Figure 8, a further embodiment of the invention will be described. The lamp fixture generally designated by 90 is fed power from an experimental set up power system generally designated by reference numeral 72.

The power system is configured as follows. A microwave or radio frequency (r.f.) source 73 generates power. The power density applied to the bulb is preferably from about a few hundred to about 10,000 watts per cubic centimeter of bulb volume.

The source 73 is coupled to a three port circulator 74 which isolates the source 73 from non-absorbed power that is reflected from the fixture 90. The circulator is connected to a power meter 75 which measures forward and reflected power and a dissipative load 76 which absorbs reflected power. Power flows through the power meter 75 to the section of waveguide 77a which is connected to the fixture. All connection lines designated by reference numerals 77, 77a represent rectangular waveguide. The dissipative load 76 is connected directly to the circulator 74. In a finalized production design, the power system 72 may be considerably simplified by eliminating the power meter 75, circulator 74, and dissipative load 76, once the design is fixed and finally tuned.

The waveguide section 77a is connected to a stepped section 77b which comprises two steps in the height of the waveguide connected to low height section of waveguide 77c. The steps serve as an impedance transformer to partially match the impedance of the waveguide 77, 77a to that of the fixture 90 which is mounted on the top broadside 91 of the low height waveguide section 77c. The inner conductor 92 is mounted on the lower broad wall 93 of the reduced height waveguide section 77c, and extends upwards through a hole 94 in the upper broad wall 91. The inner conductor is fixed by set screw 100. The hole in the upper broad wall 91 is large enough to provide insulating gap clearance. The top 92a of the inner conductor 92 is located below the end of the bulb. In the embodiment shown, the top of the inner conductor 92 is recessed. Cooling air is fed from source 80 through line 95 to the bottom of the inner conductor 92 at the lower broad wall 93, through a bore 92b up the length of the inner conductor 92b to one or more cooling air jet orifices in the base of recess 92a and is jetted against the bulb 82. Preferably the cooling holes (not shown) comprise two holes of 0.9 mm arranged along the equator of the bulb and two holes of 0.5 mm arranged near the respective poles of the bulb. (The bulb stem 83 abuts the bulb at one pole). All the holes are arranged on a circle 3.0 mm diameter centered below the bulb. The outer conductor comprises an open cylindrical wall 96 connected to the upper broad wall 91. It is taller than the inner conductor. Although in the experimental model even with top of the outer conductor 96 open there is little leakage, the top may be capped with a suitably shaped end piece such as a flat piece or a spherical piece. The cylindrical wall 96, which may be at least partially foraminous or mesh-like, can serve as the outer conductor while at the same time being substantially transparent to the radiation of the lamp. Located around the bulb outside the outer conductor 96 is a metal reflector 99. The inner conductor 92 and the outer conductor 96 form a coaxial excitation structure, which produces high strength electromagnetic fields necessary for coupling to small, high power electrodeless discharge lamps.

The stem of the bulb 82 extends through a hole in the mesh 96 and a hole in the reflector 99 to a motor 85 to which it is mechanically coupled, which serves to rotate the bulb about an axis through the stem during operation.

In the coaxial excitation structure formed by inner conductor 92 and the outer conductor 96, high electromagnetic fields are produced in the region between the bulb 82 and the inner conductor 92. These fields might tend to create arcs between the bulb and the inner conductor were it not for the cooling air emanating from the holes in the top 92a of the inner conductor. It is noted that although the outer conductor 96 is shown as being a cylinder of diameter not much bigger that the inner conductor, it is contemplated that the outer conductor may be much larger and may serve a dual purpose such as the reflector or a housing.

In accordance with the present invention, the bulb is rotated at a high speed, which is sufficient to result in an increase in efficiency of the lamp.

Fill substances which are advantageously utilized are those which emit molecular radiation, including such substances which when excited include polymeric species. Such substances include sulfur and selenium and compounds thereof, as well as similar molecular emitters. It is noted, that in the case of sulfur, in addition to $S_2$, polymeric species such as $S_4$ and $S_6$ are also formed in the excited discharge.

Any light emitting sulfur or selenium containing fill may be used, for example those including elemental sulfur or selenium or compounds such as InS, $AS_2S_3$, $S_2Cl_2$, $Cs_2$, $In_2S_3$, SeS, $SeO_2$, $SeCl_4$, SeTe, $CSe_2$, $P_2Se$, and SeAs, as well as other light emitting compounds of sulfur and selenium. The fill may have a low vapor pressure at room temperature, and a high vapor pressure at the operating temperature of the lamp.

As mentioned above, there is an inverse relationship between bulb diameter and the rotation speed. For a sulfur containing fill, having a microwave power coupled to the bulb of at least 150 watts, wherein the angular rotation frequency is w, and the maximum bulb radius as measured from the axis of rotation is r, it has been determined that an increase in efficiency in accordance with the present invention is obtained when $w^2r$ is at least $1.75 \times 10^5$ cm/sec$^2$.

Experiment 1

A test model in which the invention was operated as will be described below had the following features: the bulb was spherical in shape with a 5 mm inside diameter and a 1/2 mm wall thickness. The bulb was made of quartz, and contained a discharge fill of 0.3 mg of sulfur and 150 torr of argon. Four cooling orifices of 0.030" diameter were equally spaced on a circle of 3.0 mm, on the end 22a of the inner conductor. The inner conductor was 4.75 mm in diameter and its end was spaced 2.0 mm away from the bulb in the axial direction. The microwave frequency was 2.45 GHz. The power coupled to the bulb was 220 watts.

For test purposes a light meter was arranged in front of reflector in the center of beam thrown by it in order to measure the light output from the bulb. With the reflector present, the reading taken is not indicative of the absolute brightness because the radiation is not isotropic from the bulb, however because the reflector collects radiation from all parts of the bulb it is indicative of the relative brightness averaged over the whole bulb as experimental parameters are changed. The bulb was rotated at 3800 RPM. This speed was sufficient to create a discharge which filled the entire bulb, and sufficient to avoid arc attachment.

Cooling air pressure of 10 PSI was required to maintain the bulb temperature below the maximum temperature specification of 1000 C., which is dictated by bulb life requirements. This amount of cooling air produced an audible noise of 83 decibels, as measured using an A Weighted response, which approximates the response of the human ear. In using different speed motors available to the inventors with speeds between 2000 RPM and 3800 RPM, no change in efficiency was detected.

Experiment 2

The same test model as used in experiment 1 was used. The rotation speed was raised to 12,000 RPM. With 10 PSI of cooling air pressure, the light output was increased 6%, and the bulb temperature dropped by about 100°C. Upon reducing the cooling air to 5 PSI the bulb temperature returned to 1000° C, and the relative output increased further, bringing the total increase in relative output to 15%. The noise from the cooling jet was reduced to 71 decibels (measured as described above) by the reduction in pressure. Thus two important advantages are realized, the first being the increase in light output, and the second being the reduction in lamp noise. In sum, it is observed that the high speed rotation alters the energy conversion efficiency characteristics of the plasma, such that more of the input energy is converted to light and less is dissipated as heat.

For small bulbs as described above, including a sulfur containing fill, threshold rotation speeds as low as 8000 RPM have shown improvements in efficiency. Since the invention can be employed with bulbs of different sizes, when speed is normalized for maximum bulb radius r, and the threshold angular frequency is w, to realize an increase in efficiency in accordance with the invention, $w^2r$ is at least $1.75 \times 10^5$ cm/sec$^2$.

After reaching threshold speed, it has been found that the efficiency increases monotonically with speed until a plateau region is reached, where there are no increases or decreases in efficiency. For the lamp specifically described above, the plateau region began at about 13,000 RPM. The threshold speed and plateau speed have been found to be dependent on the power which is coupled into the bulb, with higher powers generally requiring higher speeds.

The light source described above is a bright source which is operated at relatively high efficiency. It may be particularly useful when employed in projection systems. While the above invention has been described in connection with a bulb which is spherical in shape, this need not be the case, although bulbs wherein the ratio of maximum to minimum internal dimension is less than about 5 will be advantageous for particular applications, e.g. as a liquid crystal projection source.

Although according to the preferred embodiment as detailed above, the coaxial fixture 90 is a means of applying electromagnetic energy to the bulb, other means such as a microwave cavity, an inductive coupling coil, or capacitive coupling electrodes may be employed in the practice of the invention.

**Claims**

1. An electrodeless lamp, comprising:

   an envelope (12) containing a plasma forming fill which includes at least one of sulfur and selenium when excited which emits principally visible light, which is in the form of molecular radiation, said envelope (12) having a diameter of less than one half (1/2) inch;
   means (1) for generating electromagnetic energy;
   means (2, 3, 4, 5, 6) for coupling said electromagnetic energy to said envelope to excite said fill, which in the absence of envelope rotation or with rotation at an insufficient speed, forms a discharge (14) which does not substantially fill the interior volume of said envelope (12), and
   means (13) for rotating said envelope (12) at a fast enough rate so as to cause the discharge (15) formed by the fill to substantially fill the interior volume of the envelope (12).

2. The lamp of claim 1, wherein said discharge (14) which does not substantially fill the interior volume of said envelope (12) is an isolated discharge.

3. The lamp of claim 1, wherein said discharge (14) which does not substantially fill the interior volume of said envelope (12) causes arc attachment to occur in said envelope.

4. The lamp of claim 3, wherein said electromagnetic energy comprises microwave or R.F. energy and wherein said means for coupling comprises a coaxial structure having inner (39, 52, 60, 92) and outer conductors (44, 56, 96).

5. The lamp of claim 4, wherein said bulb is proximate to but spaced from said inner conductor (39, 52, 60, 92) and wherein said means (13) for rotating comprises means for rotating said envelope such that different parts of the envelope are proximate to said inner conductor (39, 52, 60, 92) as the envelope (12) rotates.

6. The lamp of claim 5, wherein said inner conductor (52, 60, 92) is hollow, further comprising means (52b, 62, 92b) for feeding cooling fluid through said inner conductor which is directed at said envelope (12).

7. The lamp of claim 6, wherein said inner conductor (52, 60, 92) has an opening for emitting cooling fluid having predetermined diameter, and wherein said opening is located a distance from said envelope (12) which is not further away than the length of three of said predetermined diameters.

8. The lamp of claim 1, wherein said means (13) for rotating also rotates the envelope at a fast enough rate to result in a substantial increase in efficiency of the light which is emitted from the envelope.

9. The lamp of claim 8, further comprising:

   means (10, 11, 16, 46, 48, 49, 64, 80) for directing pressurized cooling fluid at the envelope at a fluid pressure which is substantially lower than the pressure which would be necessary is the absence of said increase in efficiency.

10. The lamp of claim 3, wherein said means (13) for rotating also rotates the envelope at a fast enough rate to result in a substantial increase in efficiency of the light which is emitted from the envelope (12).

11. The lamp of claim 10, wherein said substantial increase in efficiency is at least about 10 %.

12. The lamp of claim 1, wherein said envelope (12) is visually imperfect, further comprising:

   an optical element comprising a lens and/or reflector arranged in relation to said envelope (12) to project the light which is emitted therefrom, and
   wherein said means (13) for rotating comprises means for rotating the envelope at a fast enough rate to eliminate any wobble effect in the projected light.

FIG 1a

14

12

15

12

FIG. 1b

6

9 16 12 5 4 3 2

7

17 10 8 13

21

AIR 11

FIG. 2

FIG.3

FIG 4

FIG. 6

62
62
62
62

FIG. 5

A
B
66
64
60
62

FIG 7

64
64
62
62

FIG. 8

FIG. 9

FIG. 10

FIG. 11